(19) Europäisches Patentamt
European Patent Office
Office européen des brevets

(11) **EP 2 274 632 B1**

(12) **FASCICULE DE BREVET EUROPEEN**

(45) Date de publication et mention
de la délivrance du brevet:
**12.10.2011 Bulletin 2011/41**

(51) Int Cl.:
***G01R 33/022*** *(2006.01)*    ***G01R 15/20*** *(2006.01)*

(21) Numéro de dépôt: **09742096.2**

(86) Numéro de dépôt international:
**PCT/EP2009/055483**

(22) Date de dépôt: **06.05.2009**

(87) Numéro de publication internationale:
**WO 2009/135878 (12.11.2009 Gazette 2009/46)**

(54) **STRUCTURE ET PROCÉDÉ DE FABRICATION D'UN CAPTEUR DE GRADIENT DE CHAMP MAGNÉTIQUE EN TECHNOLOGIE INTÉGRÉE**

AUFBAU EINES MAGNETFELD-GRADIENTENSORS UND VERFAHREN ZUR SEINER HERSTELLUNG IN DER INTEGRATIONSTECHNIK

STRUCTURE OF A MAGNETIC-FIELD GRADIENT SENSOR AND PROCESS FOR FABRICATING IT IN INTEGRATED TECHNOLOGY

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **07.05.2008 FR 0853051**

(43) Date de publication de la demande:
**19.01.2011 Bulletin 2011/03**

(73) Titulaire: **Commissariat à l'Énergie Atomique et aux Énergies Alternatives 75015 Paris (FR)**

(72) Inventeur: **ALBERTINI, Jean-Baptiste F-38120 Saint Egreve (FR)**

(74) Mandataire: **Ilgart, Jean-Christophe et al BREVALEX 95 rue d'Amsterdam 75378 Paris Cedex 8 (FR)**

(56) Documents cités:
WO-A-98/40757    DE-A1- 19 722 834
DE-A1-102006 021 774    DE-A1-102006 034 579
US-A- 5 719 494    US-A1- 2005 073 301

**Description**

**DOMAINE TECHNIQUE ET ART ANTERIEUR**

L'invention concerne un dispositif pour mesurer le gradient d'une composante du champ magnétique (excitation H ou induction B), un procédé de mesure de ce gradient et un procédé de réalisation de ce dispositif. Un tel dispositif peut être réalisé sous forme intégrée.

Cette invention s'applique en particulier à la mesure de courant électrique dans des conducteurs filiformes.

On connaît, par le document WO 03044541 un procédé de mesure d'un courant dans un conducteur, qui met en oeuvre la mesure de dérivées d'ordre n du champ magnétique. Ce procédé permet notamment de réduire les perturbations causées par les conducteurs parasites.

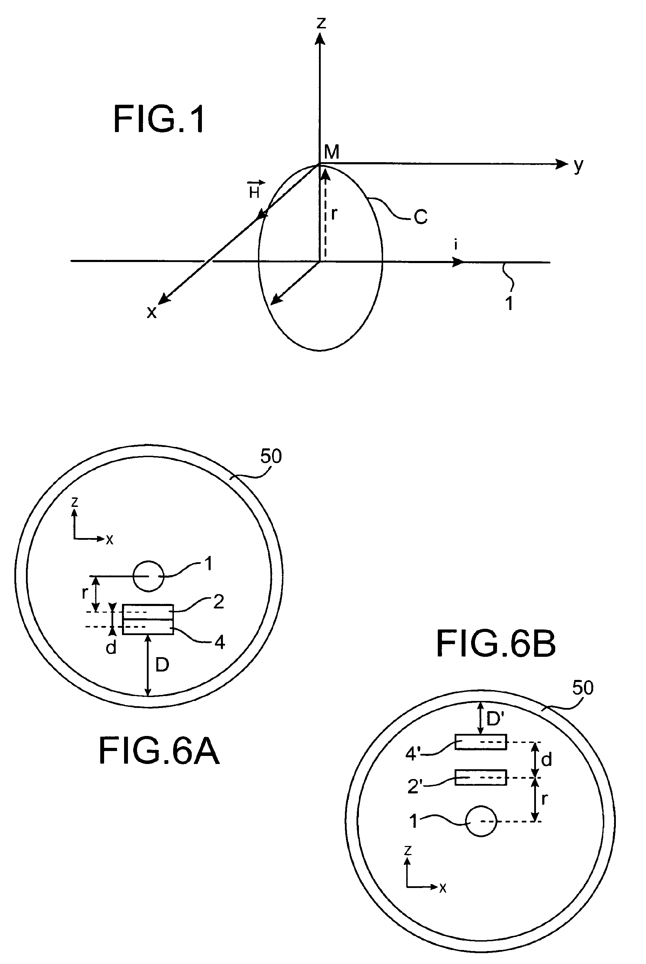

Soit un repère orthonormé xyz, représenté en figure 1, centré au point M où l'on désire faire la mesure, et où y est parallèle à l'axe d'un conducteur 1 (et situé dans le plan yMz). L'axe z est colinéaire au rayon perpendiculaire au conducteur passant par M et x est tangent au cercle C passant par M dont l'axe est le conducteur. Le champ H créé par le courant i circulant dans le conducteur 1 est alors dirigé suivant l'axe x et le gradient de Hx est dirigé sur l'axe z. La mesure du gradient du champ Hx créé par le courant i (qui décroît en $1/r^2$ en fonction de la distance r du conducteur 1), ou de dérivées d'ordre supérieur (qui décroissent encore plus rapidement en fonction de r), permet de remonter au courant i. Cette technique permet de s'affranchir mieux, dans un environnement bruité, comme par exemple celui d'une armoire électrique, des perturbations externes, que ce que permet la mesure directe du champ Hx (qui est, lui, décroissant, mais seulement en 1/r). La mesure d'un courant i1 dans un conducteur C1 en présence de conducteurs (perturbateurs) C2, C3, ... Cn, eux aussi parcourus par des courants i2, i3,... in, est ainsi rendue plus aisée, par la mesure du gradient de la composante Hx du champ H (ou d'une dérivée d'ordre supérieur à 1 de cette même composante) créé par ce conducteur, à une courte distance de ce dernier, que par la mesure directe de ce champ Hx. On cherche ainsi à obtenir une configuration dans laquelle les contributions à la grandeur mesurée, induites par les conducteurs perturbateurs sont extrêmement faibles, alors que celle induite par le conducteur principal C1 est la plus forte possible.

La mise en oeuvre de cette technique pose plusieurs problèmes.

Pour maximiser le signal, il est avantageux de disposer les capteurs (N capteurs pour une mesure de dérivée d'ordre N-1) très proches des conducteurs où l'on veut faire la mesure. Il se pose donc le problème de réduire le plus possible les distances séparant ces capteurs du conducteur 1, ainsi que les distances séparant les capteurs les uns des autres.

Ainsi, pour mesurer efficacement et précisément le courant i, il est judicieux de réaliser la mesure aux points situés le plus près possible du conducteur 1, à la distance r du centre de ce dernier. Il serait, par ailleurs, judicieux, pour mesurer précisément les dérivées du champ, que les distances entre capteurs soient plus petites que r et si possible petites devant r.

Une solution serait de miniaturiser les capteurs. Mais, si les capteurs sont miniaturisés, leur environnement (et notamment leur « packaging ») pourrait imposer des contraintes dimensionnelles minimales, qui peuvent parfois être gênantes, comme dans la configuration de la figure 5 décrite dans le document US 6154023.

On a donc du mal, dans certains cas, à réduire la distance d entre les différents capteurs.

Il serait également avantageux de pouvoir utiliser, pour ce type de mesure, des capteurs très directifs, comme des micro-fluxgates, ou des magnéto-impédances, ou des magnétorésistances avec guides de flux. Or les circuits magnétiques de ces capteurs se perturbent les uns les autres quand on rapproche trop les capteurs, d'où une mesure moins précise.

Une mesure de précision du gradient demande aussi des capteurs dont les positions relatives les unes par rapport aux autres sont très bien connues. En outre, s'ils sont très directifs (ce qui est avantageux pour réaliser une mesure non bruitée), ils doivent être parallèles entre eux, ce qui est très délicat à réaliser avec des capteurs discrets, notamment quand ils sont miniaturisés.

Un autre problème se pose lors de l'utilisation d'un capteur de gradient dans un environnement industriel. Dans ce contexte il peut être parfois nécessaire d'utiliser le capteur à l'intérieur d'un blindage magnétique qui, s'il présente l'avantage de réduire les champs perturbateurs, présente aussi l'inconvénient de créer un gradient de champ relativement important à sa proximité immédiate. Il se pose donc le problème de disposer d'un capteur de gradient, suffisamment petit pour éviter que l'un des capteurs élémentaires qui le composent ne soit trop proche du blindage qui pourrait perturber la mesure.

Il se pose en outre le problème de pouvoir disposer d'une structure de capteur réalisable en technologie collective, par exemple avec des machines du type de celles utilisées dans les domaines de la microélectronique ou des micro ou nano-technologies.

**EXPOSÉ DE L'INVENTION**

Dans la suite, on désigne par « gradient » le vecteur dérivée spatiale d'ordre n=1 d'une composante (appelée ici x) du champ magnétique (noté couramment H).

L'invention concerne d'abord un procédé de mesure d'une dérivé d'ordre n (n ≥ 1), par rapport à z ou x, d'une composante $H_x$ de champ magnétique, invariant, au moins localement, selon la direction y (x, y et z étant deux à deux perpendiculaires).

L'invention concerne notamment un procédé de mesure du gradient, ou d'une dérivé d'ordre n (n≥1), suivant une direction z ou x, d'une composante $H_x$ (suivant la direction x), d'un champ magnétique, ladite composante étant invariante, au moins localement, dans une direction y, les directions x, y, et z étant deux à deux perpendiculaires.

Ce procédé comporte :

a) le positionnement de N (N>1) capteurs de champ élémentaires dans une zone dans laquelle ladite composante de champ magnétique est invariante dans une direction y, et décalé, par rapport au capteur précédent et/ou suivant ou par rapport aux capteurs immédiatement voisins :

* selon y, d'une distance (décalage) Ty,
* selon l'axe z, d'une distance $\Delta z$ (lorsque le champ est engendré par un courant circulant dans un conducteur disposé selon y, $\Delta z$ est l'écart des capteurs par rapport à l'axe y) ;

b) la mesure du champ par chacun des N capteurs,
c) le calcul de la valeur du gradient, ou d'une dérivée d'ordre n inférieur ou égal à N - 1, en fonction des valeurs de mesure du champ obtenues lors de l'étape b).

L'invention permet, par la présence ou l'ajustement de la distance (décalage) Ty d'un capteur élémentaire par rapport aux capteurs élémentaires voisins (précédent et/ou suivant), de réduire les perturbations causées par la proximité des parties magnétiques des capteurs élémentaires voisins.

De préférence, la distance Ty est telle que la perturbation mutuelle des capteurs élémentaires voisins soit faible.

L'invention permet de réaliser une mesure dans le cas où la composante à mesurer du champ magnétique est invariante (au moins sur une courte distance) dans une direction y perpendiculaire à la direction z suivant laquelle on désire mesurer le gradient.

L'invention permet de mesurer le gradient, ou une dérivée d'ordre n inférieur ou égal à N - 1, d'une composante $H_x$ du champ à partir de capteurs, notamment lorsque ceux-ci sont très directifs, c'est-à-dire présentent une forte sélectivité de la mesure d'une composante du champ et également lorsque ces capteurs de champ comportent un circuit magnétique ou un guide de flux, comme par exemple les capteurs de type micro-fluxgate, à magnétorésistance ou encore à magnéto-impédance.

L'invention s'applique notamment à la mesure de courant dans des fils électriques par le biais de capteurs de champ magnétique situés à proximité de ces fils. En effet, par nature, le champ magnétique créé par un conducteur filiforme rectiligne dirigé suivant une direction y présente justement une invariance suivant y, puisqu'il y a une répartition cylindrique du champ suivant l'axe y.

L'invention concerne donc également un procédé de mesure de courant dans une ligne de courant, disposée suivant un axe (y), comportant :

- la mise en oeuvre d'un procédé de mesure selon l'invention, tel que décrit ci-dessus,
- le calcul du courant.

L'invention concerne également un dispositif de mesure du gradient, ou d'une dérivée d'ordre n (n>1), suivant une direction z ou x, d'une composante $H_x$ d'un champ magnétique, ladite composante étant invariante, au moins localement, dans une direction y (x, y et z étant deux à deux perpendiculaires), comportant :

- N (N>n) capteurs de champ élémentaires à disposer dans une zone dans laquelle ladite composante de champ magnétique est invariante dans une direction y, chaque capteur étant décalé, par rapport aux capteurs immédiatement voisins, précédent et/ou suivant :

* selon y, d'une distance Ty,
* selon l'axe z, d'une distance $\Delta z$, pour une mesure de la composante z du gradient ou de la dérivée d'ordre n, ou selon l'axe x, d'une distance $\Delta x$, pour une mesure de la composante x du gradient ou de la dérivée d'ordre n,
* des moyens pour calculer la valeur du gradient recherché, ou d'une dérivée d'ordre n (n≥1) recherchée, en fonction des valeurs de mesures, par exemple différentielles, du champ obtenues à l'aide desdits capteurs.

De préférence la distance Ty est telle que la perturbation mutuelle des capteurs voisins soit faible.

L'invention concerne donc également un dispositif comportant N capteurs de champ élémentaires, afin de permettre la mesure d'un champ ou de ses gradients, lorsque les N capteurs se trouvent répartis suivant une direction y, selon laquelle la grandeur à mesurer (et avantageusement ses dérivées) ne varie pas, au moins localement.

Dans un procédé ou un dispositif selon l'invention, la mesure de la composante z du gradient de la composante x du champ **H** au point M(x,y,z), pourra être réalisée, suivant l'invention, en mesurant Hx au point M(x,y,z) puis au point M' (x, y+Ty,z+ $\Delta$z) puis en calculant la quantité :

$$\text{grad}_z \text{ Hx} = (\text{Hx}(x, y+Ty, z+ \Delta z) - \text{Hx}(x,y,z))/\Delta z.$$

D'autres formules donnent les dérivés d'ordre supérieur.

Dans un procédé ou un dispositif selon l'invention, les capteurs :

- peuvent être des micro-capteurs,
- peuvent être intégrés sur un substrat commun,
- peuvent être alignés suivant un axe (AA') faisant un angle $\alpha$ avec l'axe y,
- peuvent être de type micro-fluxgate ou magnéto-résistif (notamment AMR, GMR ou TMR) ou de type magnéto-impédance.

Les capteurs d'un dispositif selon l'invention peuvent être avantageusement disposés sur, ou réalisés dans, un même substrat, par exemple en silicium, éventuellement recouvert d'une couche isolante.

Un dispositif selon l'invention peut être réalisé en fabrication collective, par exemple par des procédés de micro-nanotechnologies (ou microélectronique ou couches minces magnétiques), même dans le cas où les capteurs élémentaires sont tous réalisés sur un même substrat (de préférence en silicium recouvert d'une couche isolante) :

- chaque capteur élémentaire d'un même dispositif ayant son (ou ses) noyau(x) magnétique(s) à une cote distincte par rapport au substrat,
- ou bien : chaque capteur élémentaire d'un même dispositif ayant son (ou ses) noyau(x) magnétique(s) à une même cote par rapport au substrat, le plan du support du dispositif, avantageusement découpé dans le substrat, étant positionné de manière à présenter un angle $\alpha$ avec l'axe y lors de l'utilisation pour mesurer un champ ou une dérivée de ce champ à l'ordre n.

L'invention concerne également un procédé de réalisation d'un dispositif selon l'invention.

Un dispositif selon l'invention peut comporter un blindage (situé à distance de ce capteur).

Dans un procédé et un dispositif selon l'invention, la distance $T_y$ peut être déterminée de manière à pouvoir réaliser une mesure avec une précision p prédéfinie.

**BRÈVE DESCRIPTION DES DESSINS**

- La figure 1 représente un repère orthonormé Mxyz, ainsi que le vecteur champ magnétique H créé par un conducteur linéaire 1 filiforme parcouru par un courant i.
- La figure 2 représente un mode de réalisation d'un capteur selon l'invention.
- La figure 3 représente un autre mode de réalisation d'un capteur selon l'invention.
- La figure 4 représente encore un autre mode de réalisation d'un capteur selon l'invention.
- La figure 5 représente encore un système selon l'invention comportant un capteur selon l'invention et des moyens de traitement de données.
- Les figures 6A et 6B représentent des configurations d'un dispositif avec blindage, selon l'invention (figure 6A) et selon l'art antérieur (figure 6B).
- Les figures 7A et 7B représentent des vues en coupe, suivant deux axes, de deux capteurs élémentaires selon l'invention, la figure 8 représentant le positionnement de ces deux capteurs dans un repère xyz.
- Les figures 9A et 9B représentent deux autres dispositions de 3 capteurs élémentaires selon l'invention.

## EP 2 274 632 B1

## EXPOSÉ DÉTAILLÉ DE MODES DE RÉALISATION PARTICULIERS

L'invention peut être utilisée pour des capteurs macroscopiques aussi bien que pour des capteurs miniaturisés/intégrés. Mais elle est particulièrement bien adaptée à une mise en oeuvre de capteurs du type de ceux développés en micro-technologie.

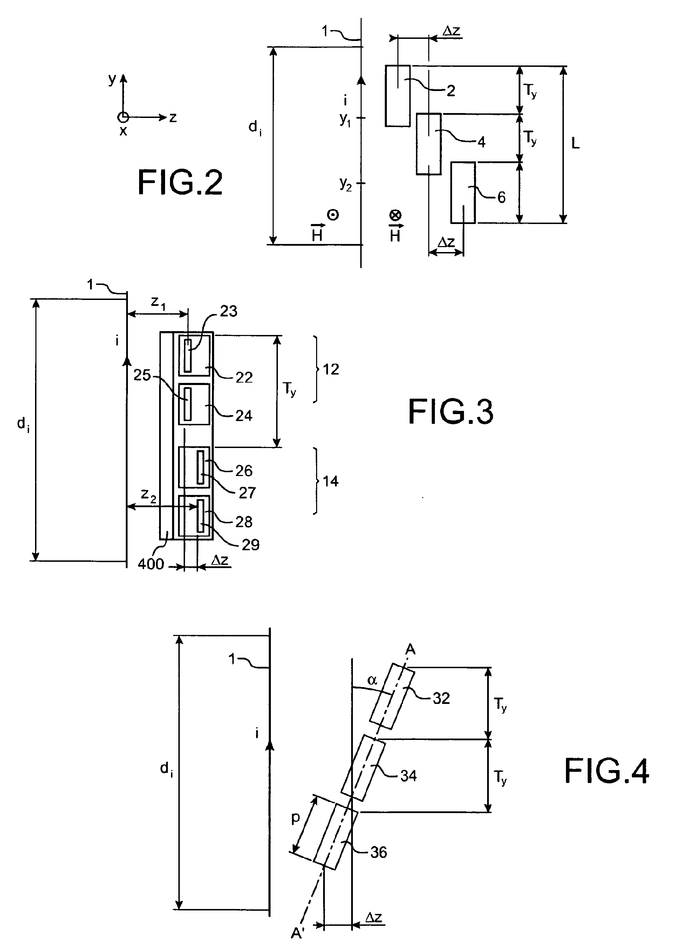

Un premier mode de réalisation de l'invention est représenté en figure 2.

Sur cette figure, un conducteur 1 est aligné suivant une direction Oy dans un repère Oxyz. Le courant i qui y circule génère un champ magnétique H dans l'espace environnant, ce champ ayant des composantes Hx, Hy, Hz dans le repère choisi.

Les capteurs élémentaires 2, 4, 6 de cette figure illustrent le cas de N = 3 capteurs, permettant de mesurer les dérivées jusqu'à l'ordre n = N-1 = 2. Chaque capteur élémentaire pourra par exemple avantageusement être choisi comme un magnétomètre à micro-fluxgate, à 1 ou 2 noyaux, dirigés suivant l'axe x et dont l'épaisseur est suivant l'axe z.

Cette structure selon l'invention permet de mesurer le gradient d'une composante du champ H, ici Hx, selon la direction z ou x, soit $dH_x/dz$ ou $dH_x/dx$, à l'aide de 2 des capteurs élémentaires, par exemple les capteurs 2, 4. Elle permet également de mesurer la dérive seconde de $H_x$ suivant z ou x, soit $d^2H_x/dz^2$ ou $d^2H_x/dx^2$, à l'aide des trois capteurs élémentaires représentés 2, 4, 6.

A cette fin, on suppose que la composante $H_x$ du champ H, donc ses dérivées jusqu'à l'ordre n, sont invariantes suivant une direction y, perpendiculaire à la direction z suivant laquelle on souhaite mesurer le gradient, au moins sur une courte distance $d_i$. Pour tout couple de points $(x, y_1, z)$ et $(x, y_2 z)$ choisis dans un certain volume autour du conducteur dans cette zone de distance $d_i$ :

$$H_x \ (x, \ y_1, \ z) \ = \ H_x \ (x, \ y_2, \ z)$$

Et :

$$dH_x(x, \ y_1, \ z)/dx \ = \ dH_x(x, \ y_2, \ z)/dx$$

La mesure du gradient $dH_x/dz$, ou $dH_x/dx$, ou la dérivée seconde ou d'ordre n quelconque pourra être réalisée en application de formules données plus loin.

Le champ magnétique créé par un conducteur filiforme rectiligne 1 dirigé suivant une direction y présente une invariance suivant y, puisqu'il y a une répartition cylindrique du champ suivant l'axe y. Un conducteur rectiligne, comme celui de la figure 2 ou des figures 3 ou 4, permet donc de satisfaire à la condition d'invariance du champ selon y.

La valeur de $d_i$ sera en fait supérieure à l'extension L du dispositif, suivant la direction y. Par exemple pour un dispositif comportant 3 micro-capteurs élémentaires, comme sur la figure 2, chacun d'une longueur, suivant la direction y, d'environ 1 mm, L sera sensiblement compris entre 2 mm et 5 mm, tandis que $d_i$ sera alors supérieur à 3 mm ou 10 mm.

La même condition sur l'extension longitudinale L (L<di) s'applique aux dispositifs des autres modes de réalisation des figures 3 et 4.

Sur la figure 2, 3 capteurs élémentaires 2, 4, 6 sont représentés dans le plan yz, ce qui permet de mesurer des dérivées d'ordre 1 ou 2. Mais on peut généraliser à N le nombre de capteurs élémentaires, ce qui permet de mesurer toute dérivée suivant z d'ordre inférieur ou égal à N-1 de la composante $H_x$ du champ. Un dispositif avec les seuls capteurs élémentaires 2, 4 permettrait de mesurer le seul gradient.

Le circuit magnétique de chaque capteur élémentaire 2, 4, 6 est disposé parallèlement à l'axe x. La projection sur l'axe y de chaque circuit magnétique ne recouvre pas, même partiellement la projection, sur l'axe y, des circuits magnétiques des capteurs voisins. Pratiquement, chaque capteur est décalé, selon y, d'une distance $T_y$ par rapport aux capteurs voisins. Cette distance $T_y$ est de préférence choisie telle que les capteurs élémentaires voisins ne puissent pas se perturber mutuellement. Un procédé de détermination de $T_y$ est donné plus loin. $T_y$ est aussi le pas du vecteur translation entre 2 capteurs élémentaires successifs suivant l'axe y.

En outre, deux circuits voisins sont décalés, dans le plan yz, selon l'axe z, d'une distance $\Delta z$, de préférence petite par rapport à z, par exemple $\Delta z/z$ < 1 % ou 5 %. Mais une valeur du rapport $\Delta z/z$ comprise entre 10 % et 50 % peut aussi être acceptable pour l'invention.

Par exemple, pour z ≈ 1 mm ou 2 mm, on choisit de préférence $\Delta z$ de l'ordre de quelques dizaines de μm.

Les mêmes considérations valent pour $\Delta x$ et $\Delta x/x$.

Les capteurs de la figure 2 peuvent être montés sur 2 ou 3 (ou N>3) puces différentes.

En variante, ils sont montés sur une même puce, ce qui présente l'avantage supplémentaire de régler le problème du positionnement précis d'un capteur par rapport à l'autre et de leur parallélisme, les capteurs élémentaires étant alors préalablement positionnés dans le plan dans lequel ils sont montés. Lorsque les capteurs sont des micro-capteurs et sont réalisés sur une même puce, la précision est au moins celle de la photolithographie. Ils sont donc alors positionnés bien plus précisément qu'avec toute autre technique de positionnement ou de micro-positionnement.

Ainsi, la figure 3 donne un exemple d'un capteur de gradient réalisé sur une puce 400 de silicium. Deux capteurs élémentaires 12, 14 sont mis en oeuvre. Chaque capteur est ici de type micro-fluxgate, à double noyau magnétique, notamment tel que décrit dans le document FR 2860594 ou FR 2900735. Mais on peut également utiliser deux capteurs de type micro-fluxgate à noyau magnétique simple, ou encore N (N>2) capteurs de type micro-fluxgates, chacun à noyau magnétique double ou simple. Dans le cas de la figure 3 (capteurs à doubles noyaux magnétiques) les noyaux 23, 25 du premier capteur sont situés à une distance z1 du conducteur 1 et les noyaux 27, 29 du second capteur à une distance z2 du conducteur 1.

La longueur des noyaux magnétiques est dirigée suivant l'axe x perpendiculaire aux figures 1 -3 (axe des lignes de champ H créées par le conducteur parcouru par le courant i).

Les bobines conductrices solénoïdales sont représentées par les cadres 22, 24, 26, 28 entourant les noyaux dans la coupe de la figure 3. Ces bobines peuvent être réalisées d'une manière commune sur l'ensemble de la puce pour l'ensemble des capteurs élémentaires (comme indiqué sur la figure 3), le décalage $\Delta z = z_2\text{-}z_1$ des noyaux magnétiques permettant de capter le champ aux deux distances souhaitées pour le calcul du gradient.

Un décalage $\Delta z = z_2\text{-}z_1$ de quelques $\mu$m peut être réalisé aisément en déposant une couche d'isolant (par exemple SiO2) d'épaisseur $\Delta z$, après avoir réalisé les noyaux du premier capteur élémentaire et avant de déposer ceux du second. On peut aussi déposer une couche d'isolant épaisse, puis la graver sélectivement à deux profondeurs différentes à l'emplacement du premier capteur élémentaire et à l'emplacement du second.

La distance Ty (« pas » des capteurs élémentaires) sépare les deux capteurs élémentaires sur la puce. La répartition des capteurs de la figure 3 permet de satisfaire à cette condition. Le capteur 12 est situé à une distance Ty du capteur 14, de sorte que la condition de non recouvrement selon l'axe y soit satisfaite.

Encore un autre mode de réalisation va être expliqué à partir de la figure 4.

N capteurs élémentaires (N=3 dans le cas de la figure 4) sont disposés alignés suivant un axe commun AA'. Leurs circuits magnétiques sont dirigés suivant l'axe x. Suivant l'axe AA', il est satisfait à la condition d'écart entre deux capteurs voisins pour qu'ils ne se perturbent pas (le pas p est supposé suffisant pour cela).

L'axe AA' est incliné par rapport au conducteur 1 d'un angle $\alpha$ suffisant pour avoir l'écart $\Delta z = p.\sin(\alpha)$ (ou $T_y = p.\cos(\alpha)$) souhaité entre deux capteurs élémentaires consécutifs. Cet angle $\alpha$ est de préférence suffisamment petit pour que la mesure de chaque capteur élémentaire ne soit pas perturbée par l'angle $\alpha$. Typiquement celui-ci pourra être compris entre 1° et 15°.

Ce mode de réalisation est tout à fait compatible avec, et adapté à, une réalisation de capteurs élémentaires identiques sur un même substrat ou sur une même puce. Il permet en effet de réaliser le décalage $\Delta z = z2\text{-}z1$ aisément, simplement en inclinant l'ensemble des capteurs par rapport à l'axe y du conducteur 1. Dans l'exemple de réalisation donné plus loin, les couches magnétiques sont déposées au même niveau sur la puce, et les capteurs élémentaires sont décalés avec un pas p sur l'axe AA'. Le décalage $\Delta z$ provient de l'inclinaison de la puce par rapport à l'axe du conducteur.

A partir de chacun des dispositifs des figures 2-4, on peut mesurer la composante en z du gradient de la composante x du champ **H** aux points où sont disposés les capteurs dans le plan y,z. En faisant tourner le dispositif de 90° autour de l'axe y, on peut mesurer la composante en x du gradient de la composante z du champ **H** aux points où sont disposés les capteurs dans le plan y, x.

Il est également possible de mesurer la composante, suivant la direction x du gradient de $H_x$, ou de ses dérivées d'ordre supérieur, en décalant les capteurs élémentaires d'un pas $\Delta x$ selon l'axe x au lieu de le faire selon l'axe z comme sur les figures 2, 3, 4. On peut alors réaliser des mesures selon l'invention, dans un même plan à coordonnée z constante, par exemple avec des capteurs de type de « micro-fluxgate », les capteurs élémentaires ayant des noyaux alignés suivants l'axe x, chacun étant décalé de $\Delta x$ selon l'axe x et de $T_y$ selon l'axe y, par rapport au précédent et/ou au suivant.

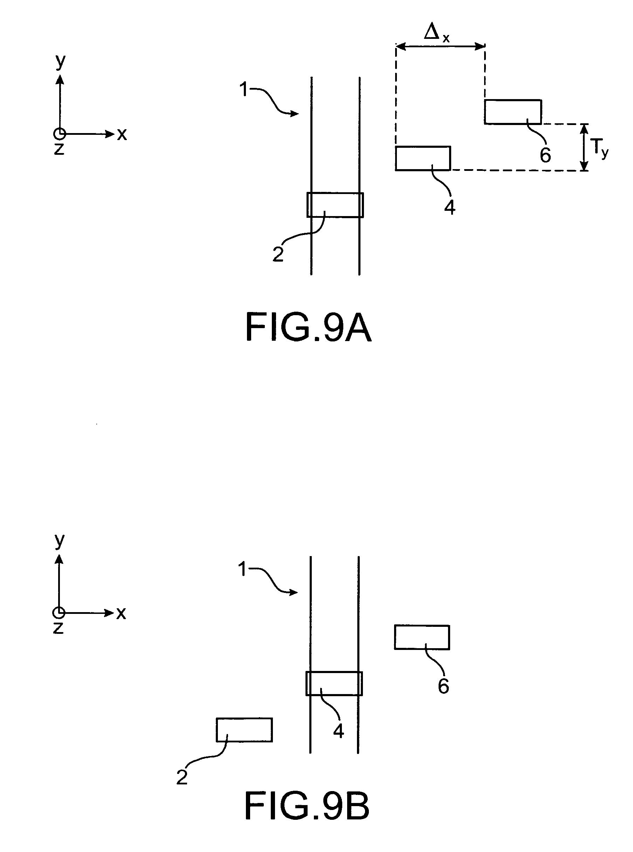

Ainsi, la figure 9A représente le cas de 3 capteurs situés dans un plan z = Constante situé au dessus du conducteur 1. Les 3 capteurs élémentaires 2, 4, 6 sont disposés dans un plan xOy avec, entre eux, un décalage Ty sur l'axe y et $\Delta x$ sur l'axe x. La figure 9B représente le cas de trois capteurs, l'ensemble étant centré au dessus du conducteur 1.

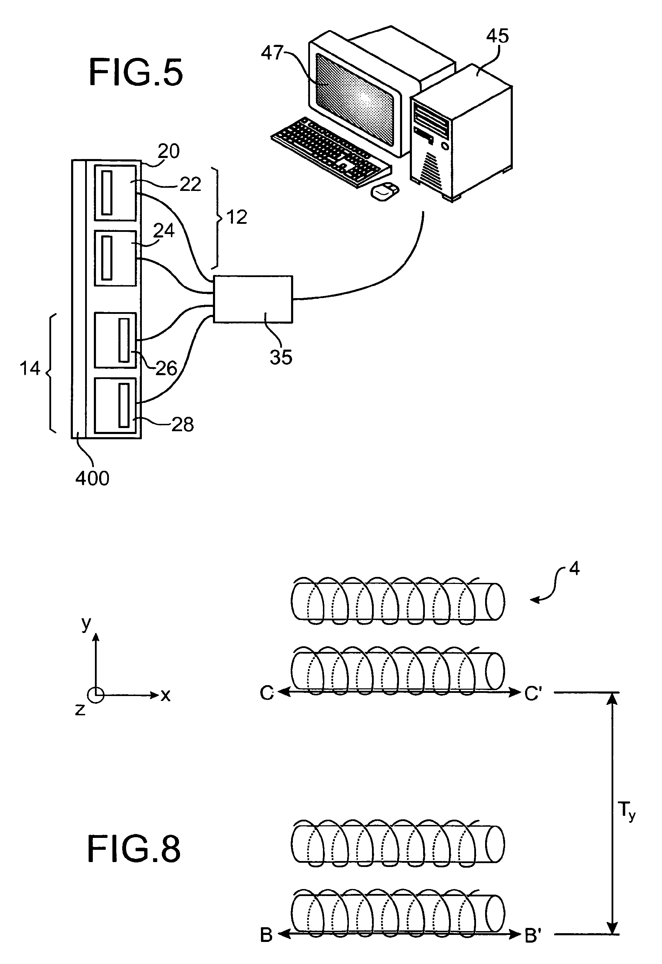

La figure 5 représente un dispositif selon l'invention et des moyens de traitement de données.

Sur cette figure, les 2 capteurs 12, 14 représentés sont associés à des moyens 35 qui regroupent par exemple des moyens de filtrage et de traitement de données, éventuellement des moyens d'amplification. Les 2 capteurs sont ceux de la figure 3, mais les moyens de traitement de donnés décrits ici peuvent s'appliquer à toute configuration décrite dans la présente demande.

Sur la figure 4 est représenté un micro-ordinateur 45 configuré de manière adaptée pour le traitement des données de gradient qui résultent des mesures effectuées par les capteurs.

Ce micro-ordinateur 45 comporte une section de calcul avec tous les composants électroniques, logiciels ou autres, qui permettront de réaliser le traitement souhaité.

Ainsi, par exemple le système 45 comporte un processeur programmable, une mémoire et un périphérique d'entrée, par exemple un disque dur, couplés à un bus système. Le processeur peut être, par exemple un micro-processeur. Des algorithmes de traitement selon l'invention, de calculs à partir de données de mesures magnétiques, comportent des instructions qui peuvent être stockées dans la mémoire, et qui permettent d'effectuer un traitement conformément à l'un quelconque des modes de réalisation de la présente invention.

Un ASIC réaliser l'ensemble des fonctions assurées par les moyens 35, 45.

Un programme, permettant de mettre en oeuvre le procédé selon l'invention est résidant ou enregistré sur un support (par exemple : disquette ou un CD ROM ou un DVD ROM ou un disque dur amovible ou un support magnétique) susceptible d'être lu par un système informatique ou par le micro-ordinateur 45.

Le micro-ordinateur 45 peut être également relié à d'autres dispositifs périphériques. Il est possible d'afficher sur l'écran 47 des données qui résultent des calculs effectués et des graphiques.

La mesure de la composante en z (ou en x) du gradient de la composante x du champ **H** au point M(x,y,z) pourra être obtenue, à partir des mesures de Hx au point M(x,y,z) puis au point M' (x, y+Ty,z+ $\Delta$z) (ou (x+ $\Delta$x, y+Ty,z)), en calculant la quantité :

$$\text{grad}_z\ H_x \approx (H_x(x,\ y+T_y,\ z+\ \Delta z)\ -\ H_x(x,y,z))/\Delta z \qquad (1).$$

Cette formule est différente de la formule de l'art antérieur :

$$\text{grad}_z\ Hx \approx (Hx(x,\ y,\ z+\ \Delta z)\ -\ Hx(x,y,z))/\Delta z)$$

Pour le gradient suivant x, on aura :

$$\text{grad}_x\ Hx \approx (Hx(x+\Delta x,\ y+Ty,z)\ -\ Hx(x,y,z))/\Delta x,$$

La dérivée d'ordre 2 s'obtient par :

$$d^{(2)}(H_x)/dz^2 \approx [H_x(x,\ y+2T_y,\ z+2\Delta z)\ -\ 2H_x(x,y+T_y,\ z+\Delta z)$$
$$+\ H_x(x,\ y,\ z)]x(1/\Delta z^2).$$

Pour la dérivée d'ordre 2 suivant x, on aura :

$$d^{(2)}(H_x)/dx^2 \approx [H_x(x+2\Delta x,\ y+2T_y,\ z)\ -\ 2H_x(x+\Delta x,y+T_y,z)$$
$$+\ H_x(x,\ y,\ z)]x(1/\Delta x^2).$$

Plus généralement, on pourra calculer une dérivée d'ordre n à partir d'une dérivée d'ordre n-1 par la formule :

$$\frac{d^{(n)}H_x(x,y,z)}{dz^{(n)}} \approx$$

$$\left[\frac{d^{(n-1)}H_x}{dz^{(n-1)}}(x,y+T_y,z+\Delta z)\ -\ \frac{d^{(n-1)}Hx}{dz^{(n-1)}}(x,y,z)\right]x\frac{1}{\Delta z}$$

ou

$$\frac{d^{(n)}H_x(x,y,z)}{dx^{(n)}} \approx$$

$$\left[ \frac{d^{(n-1)}H_x}{dx^{(n-1)}}(x+\Delta x, y+T_y, z) - \frac{d^{(n-1)}Hx}{dx^{(n-1)}}(x,y,z) \right] \times \frac{1}{\Delta x}$$

Dans le cas le plus général, on pourra utiliser toute formule d'approximation permettant de calculer $d^{(n)}(H_x)$ /$dz^n$, (ou $d^{(n)}(H_x)/dx^n$) du type :

$$\frac{d^{(n)}H_x(x,y,z)}{dz^{(n)}} \approx$$

$$\Sigma^{(N)}_{(i=1)}\alpha_i \ H_x(x+x_0, \ y+y_0, \ z+z_0+i\Delta z)$$

ou

$$\frac{d^{(n)}H_x(x,y,z)}{dx^{(n)}} \approx$$

$$\Sigma^{(N)}_{(i=1)}\alpha_i \ H_x(x+x_0+i\Delta x, \ y+y_0, \ z+z_0)$$

où le vecteur t ($x_0$, $y_0$, $z_0$) permet un recentrage de la mesure et les coefficients $\alpha_i$ peuvent dépendre de $\Delta z$ (ou de $\Delta x$).
Selon l'invention on calcule la dérivée par :

$$\frac{d^{(n)}H_x(x,y,z)}{dz^{(n)}} \approx$$

$$\Sigma^{(N)}_{(i=1)}\alpha_i \ H_x(x+x_0, \ y+y_0+iT_y, \ z+z_0+i\Delta z)$$

ou :

$$\frac{d^{(n)}H_x(x,y,z)}{dx^{(n)}} \approx$$

$$\Sigma^{(N)}_{(i=1)}\alpha_i \ H_x(x+x_0+i\Delta x, \ y+y_0+iT_y, \ z+z_0)$$

Eventuellement le même dispositif permet de calculer un courant i circulant dans un conducteur 1. A partir des mesures de gradient, le courant est obtenu par :

$$i = - 2 \Pi z^2 dH_x/dz$$

ou

$$i \approx - 2 \ (\Pi/x) \ r^3 \ dH_x/dx, \ (r = (x^2 + z^2)^{1/2})$$

Plus généralement, à partir de la dérivée d'ordre n=2, on a :

$$i = \Pi \ z^3 d^{(2)}H_x/dz^{(2)}$$

ou

$$i = 2\Pi \ [r^3/(3(x/r)^2 -1)]d^2H_x/dx^2$$

ou, à partir de la dérivée d'ordre n>2 :

$$i = (-1)^n \ (2\Pi/n!) z^{n+1}d^{(n)}H_x/dz^{(n)}$$

On peut également dériver à l'ordre souhaité les formules ci-dessus.

En variante, un circuit de traitement du signal (par exemple de type ASIC) peut être réalisé sur la même puce que le dispositif selon l'invention. Dans ce cas, la puce intègre tout ou partie des fonctions de traitement du signal décrites ci-dessus.

Un dispositif selon l'invention permet, en outre, de mieux tolérer la présence d'un blindage éventuel.

Ainsi, sur la figure 6A, sont représentés deux capteurs 2, 4 selon l'un quelconque des modes de réalisation de l'invention, disposés à proximité d'un conducteur 1. L'ensemble est entouré d'un blindage 50. Le capteur 4, le plus proche du blindage 50, est situé à une distance D de celui-ci.

La figure 6B ne diffère de la figure 6A que par les capteurs utilisés. Sur cette figure sont représentés deux capteurs 2', 4' disposés selon l'une des configurations du document US 6 154 023. Le capteur du dessus 4', le plus proche du blindage 50, est situé à une distance D', inférieure à D, de celui-ci. Le capteur 4' est donc plus perturbé par le blindage que le capteur 4 de la figure 6A.

En effet, il est tout a fait possible de réaliser un dispositif selon l'invention avec un écart $\Delta z$ allant de 1 $\mu$m à quelques centaines de $\mu$m entre deux capteurs élémentaires successifs 2, 4. Ces dimensions sont suffisamment petites pour pouvoir disposer les capteurs assez loin du blindage 50 (typiquement de quelques mm à quelques cm) afin que ceux-ci ne soient pas perturbés - ou le moins possible - par ce dernier. Dans le cas classique d'une mesure de gradient avec deux capteurs empilés l'un sur l'autre (figure 6B), la distance séparant les capteurs élémentaires est difficilement inférieure au mm (vu l'épaisseur du « packaging » associé à chaque capteur) et dans un espace limité ; le capteur élémentaire 4' le plus externe se trouve donc, de fait, plus proche du blindage 50 que dans le cas de l'invention (figure 6A).

L'invention permet de réaliser la mesure du gradient d'une composante (par exemple x) d'un champ H, par la mesure de deux valeurs $H_{x1}$ et $H_{x2}$ de ce champ en au moins deux positions $M_1$ et $M_2$ très proches. La présence du circuit magnétique du capteur mesurant le champ $H_{x1}$ ne perturbe pas la mesure du champ $H_{x2}$ de même que la présence du circuit magnétique du capteur mesurant le champ $H_{x2}$ ne perturbe pas la mesure du champ $H_{x1}$.

Elle permet également de réaliser des mesures sur une direction (par exemple z) des dérivées d'ordre n supérieur des composantes du champ magnétique : ordre 2 = $d^{(2)}(H_x)/dz^2$, ordre 3 = $d^{(3)}(Hx)/dz^3$, etc.... On rappelle ici que, avec N (N > 1) capteurs disposés selon l'invention, il est possible de réaliser des mesures permettant de calculer les dérivés jusqu'à l'ordre N-1.

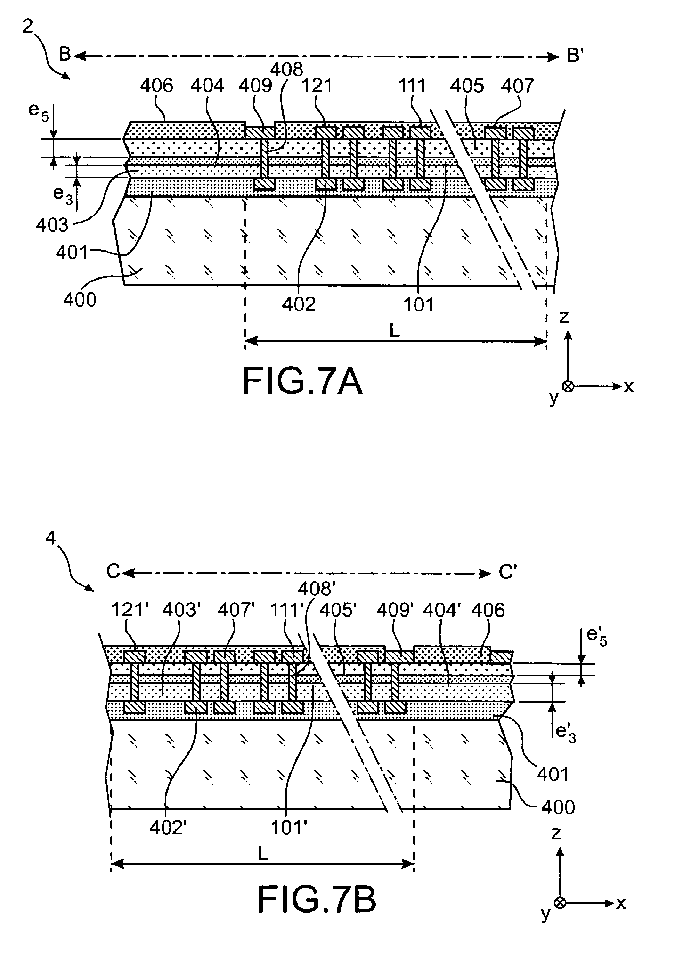

Les capteurs d'un dispositif suivant l'invention peuvent être réalisés en couches minces. Les figures 7A et 7B représentent deux vues en coupe selon les axes BB' et CC' d'une partie d'un tel dispositif, avec deux capteurs élémentaires 2, 4 (chacun ici de type microfluxgate à deux noyaux). Un repère orthonormé en marge de ces figures indique les directions respectives des axes x, y et z. La figure 8 indique schématiquement la disposition des deux capteurs élémentaires par rapport au repère Oxyz, les plans de coupe BB' et CC' des figures 7A et 7B intersectent les conducteurs au niveau des vias de connexion.

La structure de ces figures peut être généralisée à un nombre N (N>2) quelconque de capteurs individuels.

Chacun des deux capteurs élémentaires est ici réalisé par un empilement de couches minces. Une couche isolante inférieure 401 par exemple à base d'un matériau isolant tel que du $SiO_2$ ou bien tel qu'un polymère photosensible d'épaisseur par exemple comprise entre 1 et 10 micromètres, par exemple égale à 5 micromètres repose sur un substrat 400 par exemple à base de silicium. Tant la couche isolante que le substrat 400 peuvent être initialement communs aux deux capteurs, pour cette raison certaines références numériques sont les mêmes sur les deux figures 7A, 7B. La couche isolante inférieure 401 comporte des portions inférieures 402, 402' de bobinages d'excitation 121, 121' et de bobinages de détection 111, 111'. Dans chaque capteur, les bobinages de détection et d'excitations peuvent être imbriqués ou dissociés. Les portions inférieures 402, 402' de bobinages se présentent sous forme de lignes conductrices s'étendant dans une direction sensiblement parallèle à l'axe y et parallèle à un plan principal du substrat 400. Les portions inférieures 402, 402' de bobinages ont par ailleurs une forme rectangulaire dans cet exemple. En outre, ces portions inférieures 402, 402' de bobinages peuvent être réalisées à base de matériaux métalliques par exemple tels que du cuivre, de l'aluminium, de l'or...

Sur la couche isolante inférieure 401 repose une première couche diélectrique 403, 403' par exemple à base de $SiO_2$. L'épaisseur e3 de la couche 403 est différente de l'épaisseur e'3 de la couche 403', ici e3<e'3. La différence entre ces deux épaisseurs sera l'écart de distance $\Delta z$ des figures 2 ou 3 par rapport au conducteur 1 (lorsque ce conducteur est disposé suivant la direction Oy). Chacune de ces deux épaisseurs peut être comprise par exemple entre 1 et 10 micromètres.

Chaque couche diélectrique 403, 403' s'intercale entre les portions inférieures 402, 402' des bobinages 121, 121' et 111, 111' situés au-dessous d'elle et un noyau magnétique 101, 101' contenu dans une couche 404, 404' diélectrique située au-dessus d'elle. Ainsi, le noyau magnétique 101, 101' et les portions inférieures 402, 402' des bobinages sont isolés.

Chaque noyau magnétique 101, 101' s'étend dans une direction parallèle à l'axe x sur une longueur notée L. Il peut être formé à base d'un matériau magnétique tel qu'un matériau magnétique doux, un matériau magnétique amorphe, ou bien un alliage tel que par exemple un alliage à base de fer et de nickel (le NiFe, ou permalloy, peut être déposé par pulvérisation (PVD) ou par électrodéposition). Chaque noyau peut être formé en une seule couche ou par un empilement de plusieurs couches de matériaux différents et avoir une épaisseur comprise par exemple entre 500 nanomètres et 20 $\mu$m par exemple proche de 2 $\mu$m.

Sur chaque couche 404, 404' contenant le noyau 101, 101' se trouve une seconde couche diélectrique 405, 405' par exemple à base de $SiO_2$

L'épaisseur e5 de la couche 405 est différente de l'épaisseur e'5 de la couche 405', ici e'5<e5, de préférence de manière à ce que cette différence d'épaisseur compense la différence d'épaisseur, qui est en sens inverse, entre les couches 403 et 403' et que l'ensemble du dispositif garde une épaisseur uniforme sur toute sa longueur. De préférence, on a donc sensiblement : e5-e'5 ≈ e'3 - e3. La différence entre les deux épaisseurs e5 et e'5 est alors, elle aussi, de l'ordre de l'écart de distance $\Delta z$ des figures 1 ou 2 par rapport au conducteur 1 (lorsque ce conducteur est disposé suivant la direction Oy). Chacune des couches 405, 405' peut avoir une épaisseur typiquement comprise entre 1 $\mu$m et 10 $\mu$m.

La seconde couche diélectrique 405, 405' sert d'isolation entre le noyau 101, 101' situé au dessous d'elle et des portions supérieures 407, 407' des bobinages 111, 111' et 121, 121' situées au dessus d'elle et insérés dans une couche 406 située sur les couches diélectriques 405, 405'. Les différences d'épaisseur indiquées ci-dessus entre les couches 403, 403' d'une part et 405, 405' d'autre part permettent d'avoir une couche 406 d'épaisseur uniforme sur l'ensemble du dispositif.

Les portions supérieures 407, 407' de bobinages se présentent sous forme de lignes conductrices s'étendant dans une direction à peu près parallèle à Oy et parallèles à un plan principal du substrat. Les portions supérieures 407, 407' de bobinages ont une forme rectangulaire et peuvent être réalisées à base de matériaux métalliques par exemple tels que du cuivre, de l'aluminium, de l'or...

Les couches 403, 403', 404, 404', 405, 405' sont percées de manière à recevoir des raccordements verticaux 408, 408' par exemple à base de métal joignant les portions inférieures 402, 402' et les portions supérieures 407, 407' des bobinages 111, 111' et 121, 121'.

Les portions inférieures 402, 402' et supérieures 407, 407' des bobinages 111, 111' et 121, 121' reliées par les raccordements verticaux 408, 408' produisent des spires de forme approximativement ou quasi rectangulaire, s'enroulant en spirale ou le long des noyaux 101, 101'.

Des plots de connexion 409, 409' par exemple à base d'un matériau métallique sont également insérés dans la couche 406 et servent par exemple au passage de courant depuis des circuits extérieurs vers les différents bobinages ou depuis les différents bobinages vers des circuits extérieurs.

Par conséquent, pour réaliser des capteurs à des distances distinctes par rapport au substrat, la couche isolante 403 peut être réalisée plus fine sous le noyau de l'un des capteurs élémentaires que sous le noyau d'un capteur élémentaire voisin. On peut faire l'inverse pour la couche 405, de manière à ce que l'épaisseur totale des empilements des capteurs élémentaires soit la même. Pour réaliser une couche 403, 405' localement plus fine, on peut par exemple déposer une couche épaisse et la graver localement aux endroits où on désire la rendre plus fine.

Dans le cas d'un dispositif mis en oeuvre dans le cadre d'un procédé tel que décrit ci-dessus en liaison avec la figure 4, il n'est pas nécessaire de réaliser des différences d'épaisseur entre les couches d'un capteur élémentaire et du capteur voisin. Dans ce cas, la structure des figures 7A et 7B est simplifiée, toutes les couches ayant les mêmes épaisseurs d'un capteur à l'autre.

Un procédé de réalisation d'un capteur individuel peut être obtenu à partir du procédé décrit dans le document FR 2 860 594.

Des étapes de ce procédé de réalisation, pour un seul capteur sont données dans ce document en liaison avec les figures 5a-5g, sans tenir compte de la caractéristique, indiquée dans ce document précédent, selon laquelle on fait dépasser les bobinages d'excitation par rapport aux extrémités des noyaux magnétiques.

Comme expliqué ci-dessus, au cours de la réalisation de ce procédé, les épaisseurs des couches 403, 403', 405, 405' pourront être adaptées, par exemple par gravure de couches plus épaisses.

L'invention permet de réduire les perturbations causées par les conducteurs parasites. Elle s'applique à la mesure de courant par capteur de champ (sans contact) qui soit peu influencé par des perturbations magnétiques externes. Elle s'applique également à toute autre mesure de gradient d'une composante du champ magnétique dans un environnement où le champ est invariant (au moins localement) dans une direction.

Les domaines d'utilisation de la mesure de courant sont nombreux, avec par exemple :

- l'évaluation de la consommation électrique dans les bâtiments industriels, les habitations ou les moyens de transport (automobile, aviation, bateau),
- les fonctions de protection (déclanchement de disjoncteurs) dans les mêmes environnements,
- la protection des moteurs électriques dont les enroulements de cuivre coûteux gagnent à éviter les trop forts courants qui détériorent les isolants et causent des courts-circuits,
- la détection et le positionnement de câbles enterrés,
- la mesure des courants induits dans le contrôle non destructif ou la recherche de métaux.

L'ajustement du décalage $T_y$ peut être calculé, simulé ou réalisé expérimentalement dans la phase de conception, comme expliqué ci-dessous, et permet de déterminer une valeur de $T_y$ optimale pour le capteur désiré.

On va maintenant indiquer un procédé pour déterminer $T_y$ afin de minimiser les interactions des circuits magnétiques entre eux, sachant que ces interactions décroissent fortement lorsque la distance s'accroît. En d'autres termes, il s'agit là d'un procédé permettant de dimensionner $T_y$ pour faire une mesure selon l'invention avec une précision déterminée.

Supposons que l'on veuille réaliser une mesure de gradient ou d'une dérivée à l'ordre n suivant l'axe z, d'une composante Hx du champ magnétique dont l'ordre de grandeur est « h » avec une précision de « p % ». Supposons donc que l'erreur totale admissible pour la mesure soit : h.p/100 et que 2 mesures de champ soient réalisées (par exemple pour la mesure du gradient). Pour chaque mesure du champ, on tolèrera une erreur au maximum égale à :

$$(1/2).h.p/100 = h.p/200.$$

Afin d'ajuster au mieux le décalage Ty qui convient entre les capteurs élémentaires sur l'axe y, on pourra par exemple disposer un premier capteur élémentaire en situation de mesure du champ h (que l'on créera constant pour le besoin de ce dimensionnement), puis, lorsque la mesure est stabilisée, approcher progressivement le second capteur du premier sur l'axe y tout en continuant de réaliser des mesures du champ h avec ce premier capteur. Pendant l'approche du second capteur, on constatera une variation de la mesure du champ h, puisque le circuit magnétique du second capteur perturbe la mesure du premier. On peut noter l'écart « Ty min » entre les deux capteurs élémentaires lorsque le résultat de la mesure faite par le premier capteur s'écartera de « h.p/200 » de la valeur exacte h. Il suffit ensuite de prévoir la fabrication du capteur global suivant l'invention avec des capteurs élémentaires décalés d'au moins cette valeur Ty min.

En variante il est possible de réaliser une simulation numérique au lieu d'une réalisation expérimentale pour calculer cette valeur Ty min (par exemple avec un logiciel de calcul de champ magnétique par éléments finis comme, par exemple, FLUX 3D ou ANSYS), et de prendre un coefficient de sécurité pour la fabrication unitaire ou collective des capteurs avec Ty > Ty min.

Pour une mesure impliquant N capteurs (cas d'une mesure d'une dérivée d'ordre n = N-1 du champ Hx), on aura à faire un calcul impliquant une somme pondérée des N mesures. Il sera donc judicieux de borner l'erreur maximale tolérée pour chaque capteur élémentaire à, au plus, h.p/(100.N) et même plus prudemment à $h.p/(100.2^n)$ car il y a N capteurs mais la formule de calcul fait intervenir une combinaison linéaire de $2^n$ mesures.

**Revendications**

1. Procédé de mesure du gradient, ou d'une dérivée d'ordre n supérieur à 1, suivant une direction z ou x, d'une composante Hx d'un champ magnétique, ladite composante étant invariante, au moins localement, dans une direction y, les directions x, y, et z étant deux à deux perpendiculaires, comportant :

   a) le positionnement de N capteurs de champ élémentaires, N étant supérieur ou égal à n+1, dans une zone dans laquelle ladite composante de champ magnétique est invariante dans une direction y, chaque capteur étant décalé, par rapport au capteur précédent et/ou suivant :

   * selon y, d'une distance $T_y$,
   * selon l'axe z d'une distance $\Delta z$, ou selon l'axe x d'une distance $\Delta x$,

   b) la mesure du champ par chacun des N capteurs,
   c) le calcul de là valeur du gradient recherché, ou la dérivée d'ordre n recherchée, en fonction des valeurs de mesure du champ obtenues lors de l'étape b).

2. Procédé selon la revendication 1, dans lequel les capteurs sont des micro-capteurs.

3. Procédé selon l'une des revendications 1 ou 2, dans lequel les capteurs sont intégrés sur un substrat commun (400).

4. Procédé selon l'une des revendications 1 à 3, dans lequel les capteurs sont alignés suivant un axe (AA') faisant un angle $\alpha$ avec l'axe y.

5. Procédé selon la revendication 4, l'angle $\alpha$ étant compris entre 1° et 15°

6. Procédé selon l'une des revendications 1 à 5, dans lequel :

   - n=1 et on calcule la composante, suivant l'axe z ou x, du gradient de la composante Hx selon la formule :

$$\mathrm{grad_z\ Hx \approx (Hx(x,\ y+Ty,\ z+\ \Delta z)\ -\ Hx(x,y,z))/\Delta z.}$$

   Ou

$$\mathrm{grad_x\ Hx \approx (Hx(x+\Delta x,\ y+Ty,z)\ -\ Hx(x,y,z))/\Delta x,}$$

   - ou n=2 et on calcule la composante, suivant l'axe z ou x, de la dérivée d'ordre 2 de la composante Hx selon la formule :

$$\mathrm{d^{(2)}(H_x)/dz^2 \approx [(H_x(x,\ y+2T_y,\ z+2\Delta z)\ -\ 2H_x(x,y+T_y,\ z+\Delta z)}$$
$$\mathrm{+\ H_x(x,\ y,\ z)]x(1/\Delta z^2),}$$

   ou :

$$\mathrm{d^{(2)}(H_x)/dx^2 \approx [(H_x(x+2\Delta x,\ y+2T_y,\ z)\ -\ 2H_x(x+\Delta x,y+T_y,z)}$$
$$\mathrm{+\ H_x(x,\ y,\ z)]x(1/\Delta x^2).}$$

- ou n >2 et on calcule la composante, suivant l'axe z ou x, de la dérivée d'ordre n de la composante Hx selon la formule :

$$\frac{d^{(n)}H_x(x,y,z)}{dz^{(n)}} \approx \left[\frac{d^{(n-1)}H_x}{dz^{(n-1)}}(x,y+T_y,z+\Delta z) - \frac{d^{(n-1)}Hx}{dz^{(n-1)}}(x,y,z)\right]\times\frac{1}{\Delta z}$$

ou :

$$\frac{d^{(n)}H_x(x,y,z)}{dx^{(n)}} \approx \left[\frac{d^{(n-1)}H_x}{dx^{(n-1)}}(x+\Delta x,y+T_y,z) - \frac{d^{(n-1)}Hx}{dx^{(n-1)}}(x,y,z)\right]\times\frac{1}{\Delta x}$$

- ou, dans un cas plus général, la formule suivante :

$$\frac{d^{(n)}H_x(x,y,z)}{dz^{(n)}} \approx \Sigma^{(N)}{}_{(i=1)}\alpha_i \, H_x(x+x_0, \, y+y_0+iT_y, \, z+z_0+i\Delta z)$$

ou :

$$\frac{d^{(n)}H_x(x,y,z)}{dx^{(n)}} \approx \Sigma^{(N)}{}_{(i=1)}\alpha_i \, H_x(x+x_0+i\Delta x, \, y+y_0+iT_y, z+z_0)$$

où le vecteur t $(x_0, y_0, z_0)$ permet un recentrage de la mesure et les coefficients $\alpha_i$ peuvent dépendre de $\Delta z$ ou de $\Delta x$.

7. Procédé de mesure de courant dans une ligne de courant (1), disposée suivant un axe (y), comportant :

- la mise en oeuvre d'un procédé de mesure selon l'une des revendications 1 à 6 ;
- le calcul du courant.

8. Procédé selon la revendication 7; le calcul du courant étant réalisé selon la formule :

$$i = -2 \, \Pi \, z^2 dH_x/dz$$

$$ou\ i\ =\ -\ 2\ (\Pi/x)\ r^3\ dH_x/dx,\ avec\ r\ =\ (x^2\ +\ z^2)^{1/2}$$

ou, à partir de la dérivée d'ordre n=2 :

$$i\ =\ \Pi\ z^3 d^{(2)}H_x/dz^{(2)}$$

ou

$$i\ =\ 2\Pi\ [r^3/(3(x/r)^2\ -1)]d^2H_x/dx^2$$

ou, à partir de la dérivée d'ordre n>2 :

$$i\ =\ (-1)^n\ (2\Pi/n!)\ z^{n+1}d^{(n)}H_x/dz^{(n)}$$

ou selon une formule obtenue, par dérivation à l'ordre souhaité, des formules ci dessus.

**9.** Procédé selon l'une des revendications 1 à 8, dans lequel chaque capteur est de type micro-fluxgate ou magnéto-résistif (notamment AMR, GMR ou TMR) ou de type magnéto-impédance.

**10.** Dispositif de mesure du gradient ou d'une dérivée d'ordre n > 1, suivant une direction z ou suivant une direction x, d'une composante Hx d'un champ magnétique, ladite composante étant invariante, au moins localement, dans une direction y, les directions x, y et z étant deux à deux perpendiculaires, comportant :

- N capteurs de champ élémentaires, N <u>étant supérieur ou égal à</u> n+1, positionnés dans une zone dans laquelle ladite composante de champ magnétique est invariante dans une direction y, chaque capteur étant décalée par rapport au capteur précédent et/ou au capteur suivant :

 * selon y, d'une distance $T_y$,
 * selon l'axe z, d'une distance $\Delta z$, ou selon l'axe x, d'une distance $\Delta x$,

- des moyens (45) pour calculer la valeur du gradient recherché en fonction des valeurs de mesures du champ obtenues à l'aide desdits capteurs.

**11.** Dispositif selon la revendication 10, dans lequel les capteurs sont des micro-capteurs.

**12.** Dispositif selon l'une des revendications 10 ou 11, dans lequel les capteurs sont intégrés sur un substrat commun (400).

**13.** Dispositif selon l'une des revendications 10 à 12, comportant des moyens (50) de blindage qui entourent les capteurs.

**14.** Dispositif selon l'une des revendications 10 à 13, dans lequel chaque capteur est de type micro-fluxgate ou magnéto-résistif (notamment AMR, GMR ou TMR) ou de type magnéto-impédance.

**15.** Procédé selon l'une des revendications 1 à 9, ou dispositif selon l'une des revendications 10 à 14, la distance $T_y$ étant prévue supérieure à une distance minimale $T_{ymin}$, prédéterminée de sorte que la perturbation magnétique induite par l'un des capteurs n'influe pas sur les mesures effectuées par son ou ses capteurs voisins.

**Claims**

1. A method for measuring the gradient., or an n-th order derivative with n greater than 1, in a direction z or x, of a component Hx of a magnetic field, said component being invariant, at least locally, in a direction y, directions x, y, and z being perpendicular two by two, including:

   a) the positioning of N elementary field sensors, N being greater than or equal to n+1, in a zone in which said magnetic field component is invariant in a direction y, and each sensor being offset, in relation to the preceding and/or following sensor:

   * along y, by a distance $T_y$,
   * along the z axis by a distance $\Delta z$, or along the x axis by a distance $\Delta x$,

   b) the measurement of the field by each of the N sensors,
   c) the calculation of the value of the gradient, or the desired n-th order derivative, as a function of the measurement values of the field obtained during step b).

2. The method according to claim 1, in which the sensors are microsensors.

3. The method according to one of claims 1 or 2, in which the sensors are integrated on a shared substrate (400).

4. The method according to one of claims 1 to 3, in which the sensors are aligned along an axis (AA') forming an angle $\alpha$ with the y axis.

5. The method according to claim 4, the angle $\alpha$ being between 1° and 15°.

6. The method according to one of claims 1 to 5, in which:

   - n=1 and the component is calculated, along the z or x axis, of the gradient of the component Hx using formula:

   $$\mathrm{grad}_z \ Hx \ \approx \ (Hx(x, \ y+Ty, \ z+ \ \Delta z) \ - \ Hx(x,y,z))/\Delta z.$$

   Or

   $$\mathrm{grad}_x \ Hx \ \approx \ (Hx(x+\Delta x, \ y+Ty,z) \ - \ Hx(x,y,z))/\Delta x,$$

   - or n=2 and the component is calculated, along the z or x axis, of the 2nd order derivative of the component Hx using formula:

   $$d^{(2)}(H_x)/dz^2 \approx [ \ (H_x(x, \ y+2T_y, \ z+2\Delta z) \ - \ 2H_x(x,y+T_y, \ z+\Delta z)$$
   $$+ \ H_x(x, \ y, \ z)] \times (1/\Delta z^2),$$

   or:

   $$d^{(2)}(H_x)/dx^2 \approx [ \ (H_x(x+2\Delta x, \ y+2T_y, \ z) \ - \ 2H_x(x+\Delta x,y+T_y,z)$$
   $$+ \ H_x(x, \ y, \ z)] \times (1/\Delta x^2).$$

   - or n > 2 and the component is calculated, along the z or x axis, of the n-th order derivative of the component Hx using formula:

$$\frac{d^{(n)}H_x(x,y,z)}{dz^{(n)}} \approx$$

$$\left[\frac{d^{(n-1)}H_x}{dz^{(n-1)}}(x, y+T_y, z+\Delta z) - \frac{d^{(n-1)}Hx}{dz^{(n-1)}}(x,y,z)\right] \times \frac{1}{\Delta z}$$

or:

$$\frac{d^{(n)}H_x(x,y,z)}{dx^{(n)}} \approx$$

$$\left[\frac{d^{(n-1)}H_x}{dx^{(n-1)}}(x+\Delta x, y+T_y, z) - \frac{d^{(n-1)}Hx}{dx^{(n-1)}}(x,y,z)\right] \times \frac{1}{\Delta x}$$

- or, in a more general case, the following formula:

$$\frac{d^{(n)}H_x(x,y,z)}{dz^{(n)}} \approx$$

$$\Sigma^{(N)}_{(i=1)} \alpha_i H_x(x+x_0, y+y_0+iT_y, z+z_0+i\Delta z)$$

or:

$$\frac{d^{(n)}H_x(x,y,z)}{dx^{(n)}} \approx$$

$$\Sigma^{(N)}_{(i=1)} \alpha_i H_x(x+x_0+i\Delta x, y+y_0+iT_y, z+z_0)$$

where the vector t $(x_0, y_0, z_0)$ allows recentering of the measurement and the coefficients $\alpha_i$ can depend on $\Delta z$ (or on $\Delta x$).

7.  A current measuring method in a current line (1), positioned along an axis (y), including:

    - implementing a measuring method according to one of claims 1 to 6;
    - calculating the current.

8.  The method according to claim 7, the calculation of the current being done using formula:

$$i = -2 \Pi z^2 dH_x/dz$$

or

EP 2 274 632 B1

$$i = -2(\Pi/x) r^3 dH_x/dx, \text{ with } r = (x^2 + z^2)^{1/2}$$

or, from the n=2 order derivative:

$$i = \Pi z^3 d^{(2)}H_x/dz^{(2)}$$

or

$$i = 2\Pi [r^3/(3(x/r)^2 - 1)] d^2H_x/dx^2$$

or, from the n>2 order derivative:

$$i = (-1)^n (2\Pi/n!) z^{n+1}d^{(n)}H_x/dz^{(n)}$$

or according to a formula obtained, by derivation at the desired order, from the formulas above.

9. The method according to one of claims 1 to 8, in which each sensor is of the micro-fluxgate or magnetoresistive type (in particular AMR, GMR or TMR) or of the magneto-impedance type.

10. A device for measuring the gradient or an n>1.
order derivative, in a direction z or in a direction x, of a component Hx of a magnetic field, said component being invariant, at least locally, in a direction y, directions x, y, and z being perpendicular two by two, including:

- N elementary field sensors, N being greater than or equal to n+1, positioned in a zone in which said magnetic field component is invariant in a direction y, each sensor being offset, in relation to the preceding and/or following sensor:

* along y, by a distance $T_y$,
* along the z axis, by a distance $\Delta z$, or along the x axis, by a distance $\Delta x$,

- means (45) for calculating the value of the desired gradient as a function of the measurement values of the field obtained using said sensors.

11. The device according to claim 10, in which the sensors are microsensors.

12. The device according to one of claims 10 or 11, in which the sensors are integrated on a shared substrate (400).

13. The device according to one of claims 10 to 12, including shielding means (50) that surround the sensors.

14. The device according to one of claims 10 to 13, in which each sensor is of the micro-fluxgate or magnetoresistive type (in particular AMR, GMR or GMR) or of the magneto-impedance type.

15. The method according to once of claims 1 to 9, or device according to one of claims 10 to 14, the distance $T_y$, being provided to be greater than a minimum distance $T_{ymin}$, predetermined such that the magnetic disruption caused by one of the sensors does not influence the measurements done by its or their adjacent sensors.

**Patentansprüche**

1. Verfahren zur Messung eines Gradienten, oder einer Ableitung der Ordnung n größer als 1, entlang einer Richtung z oder x, einer Komponente Hx eines Magnetfeldes, wobei die Komponente, zumindest lokal, in einer Richtung y invariant ist, wobei die Richtungen x, y und z paarweise senkrecht sind, beinhaltend:

17

a) das Positionieren von N elementaren Feldsensoren, wobei N größer oder gleich n + 1 ist, in einer Zone, in welcher die Magnetfeldkomponente in einer Richtung y invariant ist, wobei jeder Sensor bezüglich des vorhergehenden und/oder folgenden Sensors versetzt ist:

- auf y um eine Distanz $T_y$,
- auf Achse z um eine Distanz $\Delta z$, oder auf Achse x um eine Distanz Ax,

b) das Messen des Feldes mittels jedem der N Sensoren,
c) das Berechnen des Wertes des gesuchten Gradienten, oder der gesuchten Ableitung der Ordnung n, in Abhängigkeit von den während Schritt b) erhaltenen Feldmesswerten.

2.  Verfahren nach Anspruch 1, bei dem die Sensoren Mikrosensoren sind.

3.  Verfahren nach einem der Ansprüche 1 oder 2, bei dem die Sensoren auf einem gemeinsamen Substrat (400) integriert sind.

4.  Verfahren nach einem der Ansprüche 1 bis 3, bei dem die Sensoren entlang einer Achse (A, A') ausgerichtet sind, die einen Winkel $\alpha$ mit der Achse y bildet.

5.  Verfahren nach Anspruch 4, wobei der Winkel $\alpha$ zwischen 1° und 15° beträgt.

6.  Verfahren nach einem der Ansprüche 1 bis 5, bei dem:

- n = 1, und die Komponente, entlang der Achse z oder x, des Gradienten der Komponente Hx gemäß folgender Formel berechnet wird:

$$\mathrm{grad}_z \, \mathrm{Hx} \approx \left( \mathrm{Hx}\left(\mathrm{x}, \quad \mathrm{y} + \mathrm{Ty}, \; \mathrm{z} + \Delta z\right) - \; \mathrm{Hx}\left(\mathrm{x}, \mathrm{y}, \mathrm{z}\right)\right) / \, \Delta z$$

oder,

$$\mathrm{grad}_x \, \mathrm{Hx} \approx \left( \mathrm{Hx}\left(\mathrm{x} + \Delta x, \quad \mathrm{y} + \mathrm{Ty}, \mathrm{z}\right) - \; \mathrm{Hx}\left(\mathrm{x}, \mathrm{y}, \mathrm{z}\right) \right) / \, \Delta x$$

- oder n = 2, und die Komponente, entlang der Achse z oder x, der Ableitung 2. Ordnung der Komponente Hx gemäß folgender Formel berechnet wird:

$$\mathrm{d}^{(2)}\left(\mathrm{Hx}\right) / \mathrm{dz}^2 \approx \left[ \left(\mathrm{Hx}\left(\mathrm{x}, \quad \mathrm{y} + 2\mathrm{T}_y, \; \mathrm{z} + 2\Delta z\right) - \; 2\mathrm{H}_x\left(\mathrm{x}, \mathrm{y} + \mathrm{T}_y, \; \mathrm{z} + \Delta z\right) \right. \right. \\ \left. \left. + \mathrm{H}_x\left(\mathrm{x}, \mathrm{y}, \mathrm{z}\right)\right] \; \mathrm{x}\left(1/\Delta z^2\right) \right.$$

oder:

$$\mathrm{d}^{(2)}\left(\mathrm{Hx}\right)/\mathrm{dx}^2 \approx \left[ \left(\mathrm{Hx}\left(\mathrm{x} + 2\Delta x, \; \mathrm{y} + 2\mathrm{T}_y, \mathrm{z}\right) - 2\mathrm{H}_x\left(\mathrm{x} + \Delta x, \mathrm{y} + \mathrm{T}_y, \mathrm{z}\right) \right. \right. \\ \left. \left. + \mathrm{H}_x\left(\mathrm{x}, \mathrm{y}, \mathrm{z}\right)\right] \; \mathrm{x}\left(1/\Delta x^2\right) \right.$$

- oder n > 2, und die Komponente, entlang der Achse z oder x, der Ableitung n-ter Ordnung der Komponente Hx gemäß folgender Formel gerechnet wird:

$$\frac{d^{(n)}H_x(x,y,z)}{dz^{(n)}} \approx$$

$$\left[\frac{d^{(n-1)}H_x}{dz^{(n-1)}}\left(x, y + T_y, z + \Delta z\right) - \frac{d^{(n-1)}Hx}{dz^{(n-1)}}\left(x, y, z\right)\right] x \frac{1}{\Delta z}$$

oder:

$$\frac{d^{(n)}H_x(x,y,z)}{dx^{(n)}} \approx$$

$$\left[\frac{d^{(n-1)}H_x}{dx^{(n-1)}}\left(x + \Delta x, y + T_y, z\right) - \frac{d^{(n-1)}Hx}{dx^{(n-1)}}\left(x, y, z\right)\right] x \frac{1}{\Delta x}$$

- oder, in einem allgemeineren Fall, der folgenden Formel:

$$\frac{d^{(n)}H_x(x,y,z)}{dz^{(n)}} \approx$$

$$\Sigma^{(N)}{}_{(i=1)} \alpha_i \, H_x\left(x + x_0, \ y + y_0 + iT_y, z + z_0 + i\Delta z\right)$$

oder:

$$\frac{d^{(n)}H_x(x,y,z)}{dx^{(n)}} \approx$$

$$\Sigma^{(N)}{}_{(i=1)} \alpha_i \, H_x\left(x + x_0 + i\Delta x, \ y + y_0 + iT_y, z + z_0\right)$$

wobei der Vektor t $(x_0, y_0, z_0)$ ein Neuzentrieren der Messung erlaubt und die Koeffizienten $\alpha_i$ von $\Delta z$ oder von $\Delta x$ abhängen können.

7. Verfahren, zum Messen von Strom in einer Stromleitung (1), die entlang einer Achse (y) angeordnet ist, beinhaltend:

- das Durchführen eines Messverfahrens nach einem der Ansprüche 1 bis 6;
- das Berechnen des Stroms.

8. Verfahren nach Anspruch 7, wobei das Berechnen des Stroms gemäß folgender Formel realisiert wird:

$$i = -2\,\Pi\,z^2 dH_x/dz$$

oder

$$i = -2\,(\Pi/x)\,r^3\,dH_x/dx, \quad \text{mit } r = (x^2 + z^2)^{1/2}$$

oder, ausgehend von der Ableitung der Ordnung n=2 :

$$i = \Pi \, z^3 d^{(2)} H_x / dz^{(2)}$$

oder

$$i = 2 \, \Pi \, [ r^3 / 3 \, (x/r)^2 - 1 ) ] \, d^2 H_x / dx^2$$

oder, ausgehend von der Ableitung der Ordnung n>2 :

$$i = (-1)^n \, ( 2\Pi / n! ) \, z^{n+1} \, d^{(n)} H_x / dx^{(n)}$$

oder gemäß einer Formel, die aus den vorhergehenden Formeln durch eine Ableitung der gewünschten Ordnung erhalten wird.

9. Verfahren nach einem der Ansprüche 1 bis 8, bei dem jeder Sensor vom Mikro-Fluxgate- oder Magnetoresistiv-(insbesondere AMR, GMR oder TMR) oder vom Magnetoimpedanz- Typ ist.

10. Vorrichtung zur Messung eines Gradienten, oder einer Ableitung der Ordnung n > 1, entlang einer Richtung z oder entlang einer Richtung x, einer Komponente Hx eines Magnetfeldes, wobei die Komponente, zumindest lokal, in einer Richtung y invariant ist, wobei die Richtungen x, y und z paarweise senkrecht sind, aufweisend:

   - N elementare Feldsensoren, wobei N größer oder gleich n + ist, werden in einer Zone positioniert, in welcher die Magnetfeldkomponente in einer Richtung y invariant ist, wobei jeder Sensor bezüglich des vorhergehenden und/oder folgenden Sensors versetzt ist:

      - auf y um eine Distanz $T_y$,
      - auf Achse z um eine Distanz $\Delta z$, oder auf Achse x um eine Distanz $\Delta x$,

   - Einrichtungen (45) zum Berechnen des Wertes des gesuchten Gradienten in Abhängigkeit von den mittels der Sensoren erhaltenen Feldmesswerten.

11. Vorrichtung nach Anspruch 10, bei dem die Sensoren Mikrosensoren sind.

12. Vorrichtung nach einem der Ansprüche 10 oder 11, bei der die Sensoren auf einem gemeinsamen Substrat (400) integriert sind.

13. Vorrichtung nach einem der Ansprüche 10 bis 12, die Abschirmungseinrichtungen (50) aufweist, welche die Sensoren umschließen.

14. Vorrichtung nach einem der Ansprüche 10 bis 13, bei der jeder Sensor vom Mikro-Fluxgate- oder Magnetoresistiv-(insbesondere AMR, GMR oder TMR) oder vom Magnetoimpedanz-Typ ist.

15. Verfahren nach einem der Ansprüche 1 bis 9, oder Vorrichtung nach einem der Ansprüche 10 bis 14, wobei die Distanz $T_y$ größer als eine minimale Distanz $T_{ymin}$ vorgesehen ist, der so vorbestimmt ist, dass die durch einen der Sensoren induzierte magnetische Störung nicht die Messungen beeinflusst, die von dem oder den benachbarten Sensoren durchgeführt werden.

# FIG.1

# FIG.6A

# FIG.6B

EP 2 274 632 B1

FIG.2

FIG.3

FIG.4

22

FIG.5

FIG.8

FIG.7A

FIG.7B

# FIG.9A

# FIG.9B

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 03044541 A
- US 6154023 A
- FR 2860594
- FR 2900735